# EUROPEAN PATENT SPECIFICATION

(11) **EP 3 976 534 B1**
(45) Date of publication and mention of the grant of the patent: **13.11.2024**
(21) Application number: 20724530.9
(22) Date of filing: 14.05.2020
(51) Int. Cl.: C02F 1/00, C02F 1/32, G01J 1/32, G01J 1/42

(54) **CONTROL CIRCUIT FOR CONTROLLING A UV LIGHT SOURCE**
STEUERUNGSSCHALTUNG ZUR STEUERUNG EINER UV-LICHT-QUELLE
CIRCUIT DE COMMANDE POUR COMMANDER UNE SOURCE DE LUMIÈRE UV

(30) Priority: 28.05.2019 EP 19177031
(43) Date of publication of application: 06.04.2022
(73) Proprietor: Watersprint AB, 223 63 Lund (SE)
(72) Inventor: LINDQVIST, Mathias, 227 31 Lund (SE); KOKKOLA, Linda, 223 52 Lund (SE); EKHOLM, Sebastian, 268 77 Kågeröd (SE)
(74) Representative: AWA Sweden AB
(86) International application number: PCT/EP2020/063495
(87) International publication number: WO 2020/239465

(56) References cited:
- WO-A1-2019/009343
- WO-A1-2019/056136
- US-A1- 2004 061 069
- US-A1- 2007 151 905
- US-A1- 2009 250 626
- US-A1- 2010 247 374
- US-A1- 2014 166 590

## Description

### Field of the invention

The invention relates to the field of purifying fluid using UV light, in particular it is related to a control circuit for controlling a UV light source configured to emit UV light into a chamber for purifying fluid.

### Background art

Decontamination by means of ultra violet (UV) light is a well-established and reliable technique for use in systems for purifying fluids, in particular systems suitable for providing potable water. These systems are efficient and perform satisfactory without the use of any chemicals. UV light in fluid purification systems has the purpose of destroying the metabolic activity, mainly the DNA of bacteria, or other microorganisms being present in the water. UV light can purify a fluid by destroying DNA/RNA of organisms present within the fluid. This prevents microorganisms from reproducing.

Typically, raw water is treated in a water supply plant whereafter this treated, refined water, frequently referred to as tap water, is made available to the end users via a water distribution system. In countries with rigorous water quality regulation, the term tap water is interchangeable with the term potable water. Elsewhere, tap water should undergo further treatment prior to being consumed. In both described cases, the tap water remains susceptible to contamination, in particular to biological infection. There have been examples when large communities and towns have had their water being infected even though their tap water on normal basis would be potable water.

When using UV light sources such as LEDs to purify fluids such as water, it is known that LEDs have a gradual degradation over time. LEDs are sensitive to high temperatures which affects the life span of the LEDs since they emit heat themselves.

Thus, there is room for improvements to LED systems to be used in systems for purifying fluid such as water.

US2014/166590A1 discloses a controller that receives UV light measurements from a UV detector and flow measurements from a flow meter and determines the actual UV dose applied to the water based on the real time UV light and flow measurements.The UV detector measures the UV light received directly from a UV source without traversing the water.

US2004/061069A1 also discloses a control circuit for controlling a UV light source configured to emit UV light into a purifying chamber of a device for purifying a fluid.

### Summary of the invention

It is an object of the present inventive concept to at least reduce the above stated issues by providing an improved control circuit for controlling a UV light source for a device for purifying fluid.

According to a first aspect, there is provided a control circuit for controlling a UV light source configured to emit UV light into a purifying chamber of a device for purifying a fluid. The control circuit comprising: a driver configured to provide the UV light source with a drive current; a fluid flow sensor configured to determine whether a flow of a fluid through the purifying chamber is present and generate a flow signal indicative thereof; a light sensor configured to measure radiant flux of light emitted from the UV light source and to generate a radiant flux signal comprising data pertaining to the measured radiant flux, wherein the light sensor is arranged to measure radiant flux of light emitted from the UV light source before the light emitted from the UV light source has entered the purifying chamber; a memory comprising a reference radiant flux; and a processor configured to: activate the UV light source upon the flow signal is indicative of presence of flow of fluid through the purifying chamber, during the UV light source being activated due to presence of flow of fluid through the purifying chamber: determine the drive current for the driver based on the measured radiant flux comprised in the radiant flux signal and the reference radiant flux, and upon the flow signal being indicative of non-presence of flow of fluid through the purifying chamber, instruct the driver to apply a drive current below a threshold to the UV-light source, wherein the threshold is set so that the radiant flux of UV-light emitted from the UV light source is ≤ 5% of a maximum radiant flux of UV-light emitted from the UV light source.

By the processor determining the drive current for the UV light source, a more efficient use of power may be achieved. The drive current determines the output of the UV light source, and in other words, the processor determines how much UV light is emitted into the purifying chamber. This may be advantageous since the life span of the UV light source may be increased. This since the UV-light source does not need to run on full power all the time. Further, by the processor determining the drive current for the UV light source, improved purifying of the fluid may be achieved. The output of the UV light source decontaminates and purifies the fluid. If the UV light output is too low, the fluid will not be effectively purified. On the other hand, if the UV light output is too high, the life span of the UV light source will be reduced. Thus, by controlling the driver current, the UV light output can be controlled such as to provide effective purifying of the fluid present in the purifying chamber and at the same time increase the life span of the UV light source.

Further, by arranging the light sensor to measure radiant flux of light emitted from the UV light source before the light emitted from the UV light source has entered the purifying chamber properties of the UV light source itself may be differentiated from properties in the purifying chamber when determine the drive current for the driver. For example, degradation of the UV light source may be differentiated from turbidity and/or sedimentations on the walls of the purifying chamber upon determine the drive current for the driver. Hence, a more efficient use of the UV light source may be provided. Further, a more confident determination on when the UV light source have degraded below a degradation threshold may be made.

When the present circuit is placed within a device for purifying a fluid such as water, a more efficient water supply system may be achieved. In such a case, the present circuit may prolong the life span of the UV light source such that said device can purify water for a longer time. Thus, the UV light source may not need to be exchanged on a frequent basis. This may provide an efficient system for purifying water.

The present control circuit provides the advantage of the UV light source being active when there is a flow of fluid to purify present in the purifying chamber. Thus, no or very little UV light is emitted when there is no fluid to purify. An environmentally friendly system for purifying a fluid may be achieved. Moreover, the control circuit provides an environmentally friendly control of the UV light source, since UV light sources need a power source to function, and the power supply is efficiently controlled by the present control circuit.

The processor may be configured to determine the drive current for the driver by: determine a degradation of the UV-light source based on the measured radiant flux comprised in the radiant flux signal and the reference radiant flux; and determine the drive current for the driver based on the degradation of the UV-light source.

The processor is configured to, upon the flow signal being indicative of non-presence of flow of fluid through the purifying chamber, instruct the driver to apply a drive current below a threshold to the UV-light source. The threshold is set so that the radiant flux of UV-light emitted from the UV light source is ≤ 5%, preferably ≤1%, of a maximum radiant flux of UV-light emitted from the UV light source. By applying such a "small" drive current to the UV light source heating of the control circuit and/or the UV light source may be provided so that moisture may be expelled from the electronics of a device comprising the UV light source, the control circuit and/or the purifying chamber. By this the life span of the UV light source and/or the control circuit may be prolonged. The "small" drive current may be applied during time periods of non-presence of flow of fluid through the purifying chamber. A length and/or periodicity of the time period(s) may be set based on a humidity measurement. The humidity measurement is made such that a humidity in the vicinity of the UV light source. The "small" drive current may be applied as long as there is no flow of fluid through the purifying chamber.

The processor may be configured to, determine a time period of non-presence of flow of fluid through the purifying chamber, and upon a length of the time period of non-presence of flow of fluid through the purifying chamber being above a threshold, active the UV light source. The UV light source is preferably activated to emit a radiant flux of ≥50% of a maximum radiant flux. This radiant flux is typically enough since the water in the purifying chamber is standing still. The activation is preferably made for a time period of 1-5 seconds. Hence, during periods of no fluid through the purifying chamber the UV light source may be used to send "flashes" of UV light into the purifying chamber in order to keep the purifying chamber disinfected. This while minimizing the uptime for the UV light source. This may enhance the life time for the UV light source. The "flashes" of UV light may be emitted with a predetermined periodicity. The periodicity may be once every 10 minutes to once every hour.

The fluid flow sensor may be configured to measure a flow rate of a fluid flowing through the purifying chamber. The flow signal may comprise data pertaining to the measured flow rate. The processor may be configured to determine the drive current for the driver based on the measured flow rate comprised in the flow signal. By this, the processor may use the data pertaining to the flow rate in order to control the output of the UV light source. In other words, the processor may control how much light is emitted into the purifying chamber based on how much fluid is flowing through the purifying chamber. Thus, a more efficient use of the UV light source may be achieved. The processor may use the data pertaining to the flow rate to determine the amount of UV light to be emitted by the UV light source into the purifying chamber. This may improve the efficiency and power usage when purifying the fluid.

The light sensor may be configured to measure UV-C light radiant flux. The reference radiant flux may be a UV-C light reference radiant flux.

The UV light source may comprise one or more UV LEDs. The one or more UV LEDs may be Waverlevel Integrated Chip On PCB (WICOP) LEDs. The one or more UV LEDs may be UV-C LEDs. The UV-C LEDs may be packaged UV-C LEDs. The processor may use the data pertaining to the flow rate to determine how many UV LEDs to activate. This may improve the efficiency of the system when purifying fluid. UV-C LEDs have a limited life span, but an advantage of using UV-C LEDs is that they may not easily break from switching on and off on a frequent basis. An advantage of using WICOP LEDs is that they may not easily break form switching on and off on a frequent basis. WICOP LEDS may provide a flexible manufacturing of the UV light source since WICOP LEDS may be easily customized. This may provide a cost efficient UV light source. This may improve the live span of the UV light source. UV-C light may operate at a wavelength of 100 to 280 nano-meters, thus have germicidal properties. Because of this, it may be beneficial to use UV-C LEDs if water is the fluid to be purified. When the control circuit is added to a system for purifying a fluid, the purifying system will thereby have a longer life span. In turn, the ability to purify fluid may be improved due to the longer life span of the purifying device.

The control circuit may comprise a temperature sensor configured to measure a temperature of a UV LED and generate a temperature signal. The processor may be configured to upon the temperature signal being indicative of that the temperature of the LED is above a predetermined temperature threshold generate a LED overheat signal. By this, the control circuit may be able to prevent any overheating of the LED of the purifying device. This may provide a cost efficient device for purifying fluid. The processor may be configured to deactivate the LED based on the overheat signal. Thus, a failure of the UV light source may be avoided. By controlling the temperature of the LED, the life span of the UV light source may be improved.

The processor may be configured to upon the radiant flux signal being indicative of that the measured radiant flux is below predetermined radiant flux threshold generate a UV light source failure signal. When the control circuit is placed within a device for purifying potable water, UV light source failure signal may reduce the risk of contaminated water passing through the device. By generating the UV light source failure signal, the UV light source may be replaced so that contaminated water does not reach the end consumer. This may be beneficial if the control circuit is placed to control a device for purifying water that is delivered as potable water to the end consumer.

In embodiments not according the present invention, the processor may be configured to deactivate the UV light source upon the flow signal is indicative of non-presence of flow of fluid through the purifying chamber. Hence, the control circuit provides control of a UV light system such that the UV light source has a prolonged life span. This is partly achieved by the UV light source being switched on and off on a continuous basis based on if there is a flow of fluid through the purifying chamber or not. The present control circuit may improve the life span of the UV light source by determining whether or not a flow of fluid is present. When there is no flow of fluid, there is no need to use up the life of the UV light source, by letting the UV light source emit light.

According to a second aspect, there is provided a device for purifying a fluid, the device comprising: a purifying chamber having a fluid inlet and a fluid outlet for allowing a flow of fluid to be purified to flow there through; a UV light source configured to emit UV light into the purifying chamber; and a control circuit according to the first aspect configured to control the UV light source.

The UV light source of the device may comprise one or more UV LEDs. The one or more UV LEDs may be WICOP LEDs. WICOP LEDs may reduce the number of LEDs with remained efficiency of the device. The one or more UV LEDs may be UV-C LEDs.

According to a third aspect, there is provided a method for controlling a UV light source configured to emit UV light into a purifying chamber of a device for purifying a fluid, the method comprising: determining whether a flow of a fluid through the purifying chamber is present; upon determining presence of flow of fluid through the purifying chamber activate the UV light source, wherein the radiant flux of UV light emitted from the UV light source before the light emitted from the UV light source has entered the purifying chamber is measured; and during the UV light source being active: measure a radiant flux being emitted from the UV light source, compare the measured radiant flux with a reference radiant flux, and adjust a drive current of the UV light source based on the comparison; and upon determining non-presence of flow of fluid through the purifying chamber applying a drive current below a threshold to the UV light source, wherein the threshold is set so that the radiant flux of UV-light emitted from the UV light source is ≤ 5% of a maximum radiant flux of UV light emitted from the UV light source.

The step of determining whether a flow of a fluid through the purifying chamber is present may comprise measuring a flow rate of the fluid flowing through the purifying chamber. The method may comprise adjusting the drive current of the UV light source based on the measured flow rate.

The method may further comprise: determining a time period of non-presence of flow of fluid through the purifying chamber, and upon a length of the time period of non-presence of flow of fluid through the purifying chamber being above a threshold, activating the UV light source for a time period of 1-5 seconds.

The step of measuring a radiant flux being emitted from the UV light source may comprise measuring a UV-C light radiant flux. The reference radiant flux may be a UV-C light reference radiant flux.

The method may comprise measuring a temperature of a LED of the UV light source. The method may comprise upon the measured temperature being above a predetermined threshold generating a LED overheat signal.

The method may comprise upon the measured radiant flux being below predetermined threshold generating a UV light source failure signal.

According to a fourth aspect, there is provided a non-transitory computer readable recording medium comprising program code portions configured to perform the method according to the third aspect when executed on when executed on the processor comprised in the control circuit of the first aspect.

Generally, the different features and advantages of the second, third, and fourth aspect have been discussed in detail in relation to the first aspect. That discussion is equally valid in relation to the second, third and fourth aspect and reference is therefore made to the above discussion. It may be noted that the various preferred embodiments or optional features are equally applicable to the second, third and fourth aspect.

A further scope of applicability of the present invention will become apparent from the detailed description given below. However, it should be understood that the detailed description and specific examples, while indicating preferred embodiments of the invention, are given by way of illustration only, since various changes and modifications within the scope of the invention as defined in the appended claims will become apparent to those skilled in the art from this detailed description.

Hence, it is to be understood that this invention is not limited to the particular component parts of the device described or acts of the methods described as such device and method may vary within the scope of the appended claims. It is also to be understood that the terminology used herein is for purpose of describing particular embodiments only, and is not intended to be limiting. It must be noted that, as used in the specification and the appended claim, the articles "a," "an," "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings does not exclude other elements or steps.

### Brief Description of the Drawings

The above and other aspects of the present invention will now be described in more detail, with reference to the appended drawings showing embodiments of the invention. The figures should not be considered limiting the invention to the specific embodiment; instead they are used for explaining and understanding the invention.
Figure 1 illustrates a control circuit.
Figure 2 illustrates a device for purifying fluid comprising the control circuit.
Figure 3 illustrates a flowchart for how to control a UV light source.

As illustrated in the figures, the sizes of layers and regions are exaggerated for illustrative purposes and, thus, are provided to illustrate the general structures of embodiments of the present invention. Like reference numerals refer to like elements throughout.

### Description of Embodiments

The present invention will now be described more fully hereinafter with reference to the accompanying drawings, in which currently preferred embodiments of the invention are shown. This invention may, however, be embodied in many different forms within the scope of the appended claims and should not be construed as limited to the embodiments set forth herein; rather, these embodiments are provided for thoroughness and completeness, and fully convey the scope of the invention to the skilled person.

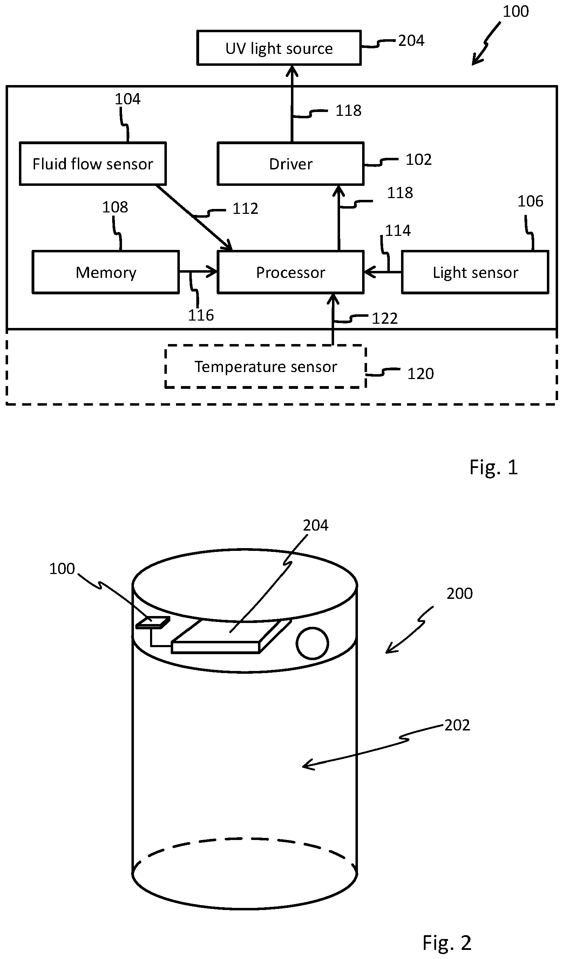

With reference to figures 1 and 2, there is disclosed a control circuit 100 for controlling a UV light source 204 of a device 200 for purifying a fluid. The device comprises a purifying chamber 202, wherein the fluid is purified when the device 200 is in use. The device 200 comprises the UV light source 204. The UV light source 204 is configured to emit UV light into the purifying chamber 202 of the device 200 for purifying a fluid. The device 200 uses UV light to decontaminate and purify fluid present in the purifying chamber 202 when the device 200 is in use. The device 200 further comprises the control circuit 100 to control the UV light source 204. In other words, the UV light emitted into the purifying chamber 202 is controlled when the device 200 is in use.

The control circuit 100 is configured to carry out overall control of the operations and functions of the UV light source 204 of the device 200. The control circuit 100 comprises a driver 102, a fluid flow sensor 104, a light sensor 106, a memory 108 and a processor 110.

The driver 102 is configured to provide the UV light source 204 with a drive current 118. The drive current 118 determines how much UV light that is emitted into the purifying chamber 202. In other words, the driver current 118 is correlated to the UV light output of the UV light source 204.

The UV light source 204 may comprise one or more UV LEDs. The one or more UV LEDs may be UV-C LEDs. The or more UV LEDs may be WICOP LEDs. WICOP LEDs may reduce the number of LEDs with remained efficiency of the device. WICOP LEDs have a smaller footprint than conventional LEDs. This may reduce a size of the UV light source 204. This may allow to make the device 200 small, allowing the device to be placed in small spaces. WICOP LEDs further require less power than regular LEDs. This may improve energy efficiency of the device. UV-C LEDs may provide the device with a more energy efficient UV light source.

The fluid flow sensor 104 is configured to determine whether a flow of a fluid through the purifying chamber 202 is present. Upon determining a presence or non-presence of fluid flow through the purifying chamber 202, the fluid flow sensor 104 is configured to generate a flow signal 112 indicative thereof. The fluid flow sensor 104 may be configured to measure a flow rate of a fluid flowing through the purifying chamber 202. The flow signal 112 may comprise data pertaining to the measured flow rate in the purifying chamber 202.

The light sensor 106 is configured to measure radiant flux of light emitted from the UV light source 204. The light sensor 106 is arranged to measure radiant flux of light emitted from the UV light source 204 before the light emitted from the UV light source 204 has entered the purifying chamber 202. Hence, the light sensor 106 may be arranged in close proximity to the UV light source 204. The light sensor 106 is further configured to generate a radiant flux signal 114. The radiant flux signal 114 comprises data pertaining to the measured radiant flux. The light sensor 106 may be configured to measure UV-C light radiant flux. Light sensor 106 may be configured to continuously measure the radiant flux. The light sensor 106 may measure an initial radiant flux when the device 200 starts up for the first time. The light sensor 106 may be configured to generate an initial radiant flux signal comprising the value of the initial radiant flux. Data pertaining to the initial radiant flux are stored in the memory 108 as a reference radiant flux 116. Hence, the memory 108 comprises the reference radiant flux 116.

The reference radiant flux 116 may be a UV-C light reference radiant flux. Alternative to measuring and storing the initial radiant flux measured at the first start-up of the device as the reference radiant flux 116, the reference radiant flux 116 may be stored in the memory 108 at manufacture of the control circuit 100, i.e. the reference radiant flux 116 may be a factory set reference radiant flux. A reference radiant flux 116 stored at manufacture of the control circuit 100 may be replaced with the initial radiant flux. Accordingly, the reference radiant flux 116 is a predetermined reference radiant flux. Upon the UV light source 204 is switched on for the first time, the at that time measured radiant flux may be set as the reference radiant flux 116. Alternatively, the reference radiant flux 116 may be a factory set reference radiant flux.

The memory 108 may be one or more of a buffer, a volatile memory, a non-volatile memory, a random access memory (RAM) or another suitable device. In a typical arrangement, the memory 108 may include a non-volatile memory for long term data storage and a volatile memory that functions as system memory for the control circuit 100. The memory 108 may exchange data within the processor 110, and possibly also the fluid flow sensor 104 and the light sensor 106, over a data bus.

The processor 110 may be a central processing unit (CPU), a microcontroller or a microprocessor. The processor 110 is configured to execute program code stored in the memory 108, in order to carry out operations and functions of the control circuit 100. The operations and functions of the control circuit 100 may be embodied in the form of executable logic routines, e.g., lines of code, software programs etc., that are stored on the memory 108 and are executed by the processor 110. Furthermore, the operations and functions of the control circuit 100 may be a stand-alone software application or form a part of a software application that carries out additional tasks related to the control circuit 100. The described operations and functions may be considered a method that the control circuit 100 is configured to carry out. Also, while the described operations and functions will be discussed as implemented in software, such functionality may as well be carried out via dedicated hardware or firmware, or some combination of hardware, firmware and/or software.

The processor 110 is configured to execute a UV light source activation function. In embodiments not comprised in the present invention, the UV light source activation function may be configured to deactivate the UV light source 204 upon the flow signal 112 being indicative of non-presence of flow of fluid through the purifying chamber 202. In other words, when there is no flow of fluid in the purifying chamber 202, the UV light source 204 is switched to an off mode. According to the present invention, the UV light source activation function is further configured to activate the UV light source upon the flow signal is indicative of presence of flow of fluid through the purifying chamber. In other words, when there is a flow of fluid in the purifying chamber 202, the UV light source 204 is switched to an on mode. In embodiments not comprised in the present invention, the UV light source 204 may not use any power when there is no fluid to be purified present in the purifying chamber 202. This may improve the life span of the UV light source. This may achieve an efficient and environmentally friendly device for purification of fluid.

The processor 110 is further configured to execute a drive current setting function. The drive current setting function is configured to determine a drive current 118 for the driver 102. Especially, the drive current setting function is configured to, upon the UV light source being active, determine the drive current 118 for the driver 102. The drive current setting function is configured to set the drive current 118 for the driver 102 based on the measured radiant flux being comprised in the radiant flux signal 114 and the reference radiant flux 116 stored in the memory 108. This may be accomplished through comparing the measured radiant flux with the reference radiant flux 116 and thereafter setting the drive current 118 based on said comparison.

The drive current setting function may further be configured to base the setting of the drive current 118 for the driver 108 on the measured flow rate comprised in the flow signal 112. The drive current setting function may compensate a loss of radiant flux by adjusting the drive current 118 such that efficiency of the UV light source is retained.

The drive current setting function is configured to, upon the flow signal 112 being indicative of non-presence of flow of fluid through the purifying chamber 202, instruct the driver 102 to apply a drive current 118 below a threshold to the UV-light source 204. The threshold is set so that the radiant flux of UV-light emitted from the UV light source is ≤ 5%, preferably ≤ 1%, of a maximum radiant flux of UV-light emitted from the UV light source 204. By this moisture may be expelled from the device 200 for purifying a fluid.

The UV light source activation function may be configured to determine a time period of non-presence of flow of fluid through the purifying chamber 202. The drive current setting function may be configured to, upon a length of the time period of non-presence of flow of fluid through the purifying chamber 202 is above a threshold, active the UV light source 204. Upon doing so, the drive current setting function is preferably set to activate the UV light source 204 to emit a radiant flux of ≥50% of a maximum radiant flux. The activation is preferably made for a time period of 1-5 seconds. Hence, during periods of no fluid through the purifying chamber 202 the UV light source 204 may be used to send "flashes" of UV light into the purifying chamber 202 in order to keep the purifying chamber 202 disinfected. This while minimizing the uptime for the UV light source 204. The "flashes" of UV light may be emitted with a predetermined periodicity. The periodicity may be once every 10 minutes to once every hour.

The processor 112 may further be configured to execute a fail test function. The fail test function is configured to check whether the radiant flux signal being indicative of that the measured radiant flux is below a predetermined radiant flux threshold. If so, the fail test function is configured to generate a UV light source failure signal. The predetermined radiant flux threshold may be factory set threshold. The predetermined radiant flux threshold may be indicative of how much UV-light that is needed to effectively purify and decontaminate the fluid. The predetermined radiant flux threshold may have different values depending on which type of fluid is to be purified in the purifying chamber 202. For example, the fail test function may be configured to generate the UV light source failure signal when the measured radiant flux is below 70% of the reference radiant flux.

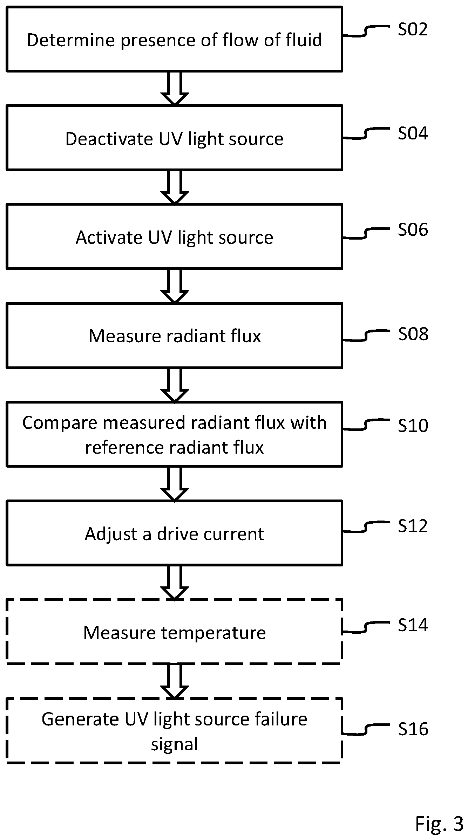

In connection with Fig. 3, a method for controlling a UV light source (204) will be discussed. Especially, for controlling a UV light source (204) configured to emit UV light into a purifying chamber (202) of a device (200) for purifying a fluid. The steps of the method may be performed in any order suitable. The method comprises the following steps.

Determining S02 whether a flow of a fluid through the purifying chamber is present. Upon determining presence of flow of fluid through the purifying chamber activate S06 the UV light source. During the UV light source being active: measure S08 a radiant flux being emitted from the UV light source 204, compare S10 the measured radiant flux with a reference radiant flux 116, and adjust S12 a drive current of the UV light source based on the comparison. The act of measuring S08 the radiant flux being emitted from the UV light source 204 is made on UV light emitted from the UV light source 204 before the light emitted from the UV light source 204 has entered the purifying chamber 204. Hence, preferably, UV light directly after the UV light source is measured.

The step of determining S02 whether a flow of a fluid through the purifying chamber 202 is present may comprise measuring a flow rate of the fluid flowing through the purifying chamber. The step of adjusting S12 the drive current of the UV light source may further be based on the measured flow rate.

The step of measuring S08 a radiant flux being emitted from the UV light source may comprise measuring a UV-C light radiant flux. The reference radiant flux may be a UV-C light reference radiant flux.

The method may further comprise measuring S14 a temperature of a LED of the UV light source. Upon the measured temperature being above a predetermined threshold a LED overheat signal may be generated.

The method may further comprise upon the measured radiant flux being below a predetermined threshold, generate S16 a UV light source failure signal.

The method may further comprise in embodiments not comprised in the present invention, upon determining non-presence of flow of fluid through the purifying chamber deactivate S04 the UV light source.

The method further comprises, upon determining non-presence of flow of fluid through the purifying chamber, applying a drive current below a threshold to the UV light source.

The method may further comprise: determining a time period of non-presence of flow of fluid through the purifying chamber, and upon a length of the time period of non-presence of flow of fluid through the purifying chamber being above a threshold, activating the UV light source for a time period. The time period may be in the range of 1-5 seconds.

The person skilled in the art realizes that the present invention by no means is limited to the preferred embodiments described above. On the contrary, many modifications and variations are possible within the scope of the appended claims.

For example, the control unit 100 may further comprise a temperature sensor 120. The temperature sensor 120 may be configured to measure a temperature of the UV light source 204. The temperature sensor 120 may be configured to measure a temperature of an individual UV LED of the UV light source 204. The temperature sensor 120 may be configured to generate a temperature signal 122. For example, the temperature sensor 120 may be configured to measure a temperature at a P-N junction of the individual UV LED. The temperature signal 122 may comprise a temperature of a surrounding of the individual UV LED. The temperature signal 122 may comprise a temperature of the individual UV LED. The processor 110 may be configured to execute an overheat checking function. The overheat checking function is configured to use the temperature signal from the temperature sensor 120 as input. For example, the overheat checking function may be configured to, upon the temperature signal being indicative of that the temperature of an individual UV LED is above a predetermined temperature threshold generate a LED overheat signal. The overheat checking function may be configured to deactivate the individual LED upon the temperature signal being indicative of that the temperature of the individual LED is above the predetermined temperature threshold. The predetermined temperature threshold may be a factory set threshold.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A control circuit (100) for controlling a UV light source (204) configured to emit UV light into a purifying chamber (202) of a device (200) for purifying a fluid, the control circuit (100) comprising:
a driver (102) configured to provide the UV light source (204) with a drive current (118);
a fluid flow sensor (104) configured to determine whether a flow of a fluid through the purifying chamber (202) is present and generate a flow signal (112) indicative thereof;
a light sensor (106) configured to measure radiant flux of light emitted from the UV light source (204) before the light emitted from the UV light source (204) has entered the purifying chamber (202) and to generate a radiant flux signal (114) comprising data pertaining to the measured radiant flux;
a memory (108) comprising a reference radiant flux (116); and
a processor (110) configured to:
upon the flow signal (112) being indicative of presence of flow of fluid through the purifying chamber (202), activate the UV light source (204);
during the UV light source (204) being activated due to presence of flow of fluid through the purifying chamber (202), determine the drive current (118) for the driver (102) based on the measured radiant flux comprised in the radiant flux signal (114) and the reference radiant flux (116); and
upon the flow signal (112) being indicative of non-presence of flow of fluid through the purifying chamber (202), instruct the driver to apply a drive current (118) below a threshold to the UV-light source (204), wherein the threshold is set so that the radiant flux of UV-light emitted from the UV light source is ≤ 5% of a maximum radiant flux of UV-light emitted from the UV light source.

2. The control circuit (100) according to claim 1, wherein the processor (110) is configured to determine the drive current (118) for the driver (102) by determine a degradation of the UV-light source (204) based on the measured radiant flux comprised in the radiant flux signal (114) and the reference radiant flux (116), and determine the drive current (118) for the driver (102) based on the degradation of the UV-light source (204).

3. The control circuit (100) according to claim 1 2, wherein the processor (110) is configured to:
determine a time period of non-presence of flow of fluid through the purifying chamber (202), and
upon a length of the time period of non-presence of flow of fluid through the purifying chamber (202) is above a threshold, active the UV light source (204).

4. The control circuit (100) according to any one of claims 1-3, wherein the fluid flow sensor (104) is further configured to measure a flow rate of a fluid flowing through the purifying chamber (202), wherein the flow signal (112) comprises data pertaining to the measured flow rate, and wherein the processor (110) is further configured to determine the drive current (118) for the driver (102) based on the measured flow rate comprised in the flow signal (112).

5. The control circuit (100) according to any one of claims 1-4, wherein the light sensor (106) is configured to measure UV-C light radiant flux and wherein the reference radiant flux (116) is a UV-C light reference radiant flux.

6. The control circuit (100) according to any one of claims 1-5, wherein the UV light source (204) comprises one or more UV LEDs, wherein the control circuit (100) further comprises a temperature sensor (120) configured to measure a temperature of a UV LED and generate a temperature signal (122), wherein the processor (110) is configured to upon the temperature signal (122) being indicative of that the temperature of the LED is above a predetermined temperature threshold generate a LED overheat signal.

7. The control circuit (100) according to any one of claims 1-6, wherein the processor (110) is configured to upon the radiant flux signal (114) being indicative of that the measured radiant flux is below a predetermined radiant flux threshold generate a UV light source failure signal, wherein the predetermined radiant flux threshold is a factory set threshold.

8. A device (200) for purifying a fluid, the device (200) comprising:
a purifying chamber (202) having a fluid inlet and a fluid outlet for allowing a flow of fluid to be purified to flow there through;
a UV light source (204) configured to emit UV light into the purifying chamber (202); and
a control circuit (100) according to any one of claims 1-7, configured to control the UV light source (204).

9. A method for controlling a UV light source (204) configured to emit UV light into a purifying chamber (202) of a device (200) for purifying a fluid, the method comprising:
determining (S02) whether a flow of a fluid through the purifying chamber (202) is present;
upon determining presence of flow of fluid through the purifying chamber (202) activate (S06) the UV light source (204);
during the UV light source (204) being active:
measure (S08) a radiant flux being emitted from the UV light source (204) before the light emitted from the UV light source (204) has entered the purifying chamber (202),
compare (S10) the measured radiant flux with a reference radiant flux (116), and
adjust (S12) a drive current (118) of the UV light source (204) based on the comparison; and
upon determining non-presence of flow of fluid through the purifying chamber (202) applying a drive current (118) below a threshold to the UV light source (204), wherein the threshold is set so that the radiant flux of UV-light emitted from the UV light source is ≤ 5% of a maximum radiant flux of UV-light emitted from the UV light source.

10. The method according to claim 9, further comprising:
determining a time period of non-presence of flow of fluid through the purifying chamber (202), and
upon a length of the time period of non-presence of flow of fluid through the purifying chamber (202) being above a threshold, activating the UV light source (204) for a time period of 1-5 seconds.

11. The method according to claim 9 or 10, wherein the step of determining (S02) whether a flow of a fluid through the purifying chamber (202) is present comprises measuring a flow rate of the fluid flowing through the purifying chamber, wherein the method further comprises adjusting the drive current of the UV light source based on the measured flow rate.

12. The method according to any one of claims 9-11, wherein the step of measuring (S08) a radiant flux being emitted from the UV light source (204) comprises measuring a UV-C light radiant flux and wherein the reference radiant flux (116) is a UV-C light reference radiant flux.

13. The method according to any one of claims 9-12, further comprising measuring (S14) a temperature of a LED of the UV light source (204), upon the measured temperature being above a predetermined threshold generate a LED overheat signal.

14. The method according to any one of claims 9-13, further comprising upon the measured radiant flux being below a predetermined threshold generate (S16) a UV light source failure signal.

15. A non-transitory computer readable recording medium comprising program code portions configured to perform the method according to any one of claims 9-13 when executed on the processor (110) comprised in the control circuit (100) of any one of claims 1-7.

## Patentansprüche

1. Steuerungsschaltung (100) zum Steuern einer UV-Lichtquelle (204), die zum Ausgeben von UV-Licht in eine Reinigungskammer (202) eines Geräts (200) zum Reinigen einer Flüssigkeit ausgestattet ist, wobei die Steuerungsschaltung (100) umfasst:
einen Antrieb (102), der ausgestaltet ist, um der UV-Lichtquelle (204) einen Antriebsstrom (118) bereitzustellen;
einen Flüssigkeitsstrom-Sensor (104), der ausgestaltet ist, um zu bestimmen, ob ein Strom einer Flüssigkeit durch die Reinigungskammer (202) vorhanden ist und ein Stromsignal (112) zu erzeugen, das dies anzeigt;
einen Lichtsensor (106), der ausgestaltet ist, um einen Strahlungs-Lichtfluss zu messen, der von der UV-Lichtquelle (204) ausgegeben ist, bevor das von der UV-Lichtquelle (204) ausgegebene Licht in die Reinigungskammer (202) eingetreten ist, und um ein Strahlungs-Flusssignal (114) zu erzeugen, das Daten umfasst, die den gemessenen Strahlungsfluss betreffen;
einen Speicher (108), der einen Strahlungs-Referenzfluss (116) umfasst; und
einen Prozessor (110), der ausgestaltet ist, um:
beim Flusssignal (112), das das Vorhandensein eines Flüssigkeitsstroms durch die Reinigungskammer (202) anzeigt, die UV-Lichtquelle (204) zu aktivieren;
während die UV-Lichtquelle (204) aufgrund des Vorhandenseins des Flüssigkeitsstroms durch die Reinigungskammer (202) aktiviert ist, den Antriebsstrom (118) für den Antrieb (102) auf der Grundlage des gemessenen Strahlungsstroms, der in dem Strahlungs-Flusssignal (114) umfasst ist, und den Strahlungs-Referenzfluss (116) zu bestimmen; und
wenn das Flusssignal (112) das Nicht-Vorhandensein des Flüssigkeitsstroms durch die Reinigungskammer (202) anzeigt, den Antrieb anzuweisen, einen Antriebsstrom (118) unterhalb eines Grenzwertes auf die UV-Lichtquelle (204) anzuwenden, wobei der Grenzwert derart eingestellt ist, dass der Strahlungs-UV-Lichtstrom, der von der UV-Lichtquelle ausgegeben ist, ≤ 5 % eines maximalen Strahlungs-UV-Lichtstroms ist, der von der UV-Lichtquelle ausgegeben ist.

2. Steuerungsschaltung (100) nach Anspruch 1, wobei der Prozessor (110) ausgestaltet ist, um den Antriebsstrom (118) für den Antrieb (102) durch Bestimmen einer Verschlechterung der UV-Lichtquelle (204) auf der Grundlage des gemessenen Strahlungsflusses in dem Strahlungs-Flusssignal (114) und dem Strahlungs-Referenzfluss (116) zu bestimmen, und den Antriebsstrom (118) für den Antrieb (102) auf der Grundlage der Verschlechterung der UV-Lichtquelle (204) zu bestimmen.

3. Steuerungsschaltung (100) nach Anspruch 1, 2, wobei der Prozessor (110) ausgestaltet ist, um:
eine Zeitdauer des Nicht-Vorhandenseins eines Flüssigkeitsstroms durch die Reinigungskammer (202) zu bestimmen, und
bei einer Länge der Zeitdauer des Nicht-Vorhandenseins eines Flüssigkeitsstroms durch die Reinigungskammer (202) oberhalb des Grenzwertes, die UV-Lichtquelle (204) zu aktivieren.

4. Steuerungsschaltung (100) nach irgendeinem der Ansprüche 1 - 3, wobei der Flüssigkeitsstrom-Sensor (104) weiterhin ausgestaltet ist, um einen Durchfluss einer Flüssigkeit zu messen, die durch die Reinigungskammer (202) fließt, wobei das Flusssignal (112) Daten umfasst, die den gemessenen Durchfluss betreffen, und wobei der Prozessor (110) weiterhin ausgestaltet ist, um den Antriebsstrom (118) für den Antrieb (102) auf der Grundlage des gemessenen Durchflusses zu bestimmen, der in dem Flusssignal (112) umfasst ist.

5. Steuerungsschaltung (100) nach irgendeinem der Ansprüche 1 - 4, wobei der Lichtsensor (106) ausgestaltet ist, um den Strahlungs-UV-C-Lichtstrom zu messen und wobei der Strahlungs-Referenzfluss (116) ein Strahlungs-UV-C-Referenzfluss ist.

6. Steuerungsschaltung (100) nach irgendeinem der Ansprüche 1 - 5, wobei die UV-Lichtquelle (204) eine oder mehrere UV-LED(s) umfasst, wobei die Steuerungsschaltung (100) weiterhin einen Temperatursensor (120) umfasst, der ausgestaltet ist, um eine Temperatur einer UV-LED zu messen und ein Temperatursignal (122) zu erzeugen, wobei der Prozessor (110) ausgestaltet ist, um beim Temperatursignal (122), das anzeigt, dass die Temperatur der LED eine vorbestimmte Temperatur übersteigt, ein LED-Überhitzungssignal erzeugt.

7. Steuerungsschaltung (100) nach irgendeinem der Ansprüche 1 - 6, wobei der Prozessor (110) ausgestaltet ist, um beim Strahlungs-Flusssignal (114), das anzeigt, dass der gemessene Strahlungsfluss einen vorbestimmten Strahlungs-Flussgrenzwert unterschreitet, ein UV-Lichtquellenausfallsignal zu erzeugen, wobei der vorbestimmte Strahlungs-Flussgrenzwert ein werksseitig eingestellter Grenzwert ist.

8. Gerät (200) zum Reinigen einer Flüssigkeit, wobei das Gerät (200) umfasst:
eine Reinigungskammer (202) mit einem Flüssigkeitseinlass und einem Flüssigkeitsauslass, damit ein zu reinigender Flüssigkeitsstrom hindurchströmen kann;
eine UV-Lichtquelle (204), die ausgestaltet ist, um UV-Licht in die Reinigungskammer (202) auszugeben; und
eine Steuerungsschaltung (100) nach irgendeinem der Ansprüche 1 - 7, die ausgestaltet ist, um die UV-Lichtquelle (204) zu steuern.

9. Verfahren zum Steuern einer UV-Lichtquelle (204), die ausgestaltet ist, um UV-Licht in eine Reinigungskammer (202) eines Geräts (200) zum Reinigen einer Flüssigkeit auszugeben, wobei das Verfahren umfasst:
Bestimmen (S02), ob ein Strom einer Flüssigkeit durch die Reinigungskammer (202) vorhanden ist;
beim Feststellen des Vorhandenseins einer Flüssigkeit durch die Reinigungskammer (202) Aktivieren (S06) der UV-Lichtquelle (204);
während die UV-Lichtquelle (204) aktiv ist;
Messen (S08) eines Strahlungsflusses, der von der UV-Lichtquelle (204) ausgegeben wird, bevor das von der UV-Lichtquelle (204) ausgegebene Licht in die Reinigungskammer (202) eingetreten ist,
Vergleichen (S10) des gemessenen Strahlungsflusses mit einem Strahlungs-Referenzfluss (116), und
Anpassen (S12) eines Antriebsstroms (118) der UV-Lichtquelle (204) auf der Grundlage des Vergleichs; und
beim Feststellen des Nicht-Vorhandenseins eines Flüssigkeitsstroms durch die Reinigungskammer (202), Anlegen eines Antriebsstroms (118) unterhalb eines Grenzwerts auf die UV-Lichtquelle (204), wobei der Grenzwert derart eingestellt wird, dass der Strahlungsstrom des UV-Lichtes, der von der UV-Lichtquelle ausgegeben wird, ≤ 5 % eines maximalen Strahlungsstroms des UV-Lichts beträgt, der von der UV-Lichtquelle ausgegeben wird.

10. Verfahren nach Anspruch 9, weiterhin umfassend:
Bestimmen einer Zeitdauer des Nicht-Vorhandenseins eines Flüssigkeitsstroms durch die Reinigungskammer (202) und
bei einer Länge der Zeitdauer des Nicht-Vorhandenseins eines Flüssigkeitsstroms durch die Reinigungskammer (202), die einen Grenzwert übersteigt, Aktivieren der UV-Lichtquelle (204) über eine Zeitdauer von 1 - 5 Sekunden.

11. Verfahren nach Anspruch 9 oder 10, wobei der Schritt zum Bestimmen (S02), ob ein Flüssigkeitsstrom durch die Reinigungskammer (202) vorhanden ist, das Messen eines Durchflusses des Flüssigkeitsstroms durch die Reinigungskammer umfasst, wobei das Verfahren weiterhin das Anpassen des Antriebsstroms der UV-Lichtquelle auf der Grundlage des gemessenen Durchflusses umfasst.

12. Verfahren nach irgendeinem der Ansprüche 9 - 11, wobei der Messschritt (S08) eines Strahlungsflusses, der von der UV-Lichtquelle (204) ausgegeben wird, das Messen eines Strahlungs-UV-C-Lichtstroms umfasst und wobei der Strahlungs-Referenzstrom (116) ein Strahlungs-UV-C-Referenzstrom ist.

13. Verfahren nach irgendeinem der Ansprüche 9 - 12, weiterhin umfassend das Messen (S14) einer Temperatur einer LED der UV-Lichtquelle (204), wenn die gemessene Temperatur einen vorbestimmten Grenzwert übersteigt, Erzeugen eines LED-Überhitzungssignals.

14. Verfahren nach irgendeinem der Ansprüche 9 - 13, weiterhin umfassend das Erzeugen (S16) eines UV-Lichtquellenausfallsignals, wenn der gemessene Strahlungsfluss einen vorbestimmten Grenzwert unterschreitet.

15. Nicht-transitorisches, computerlesbares Aufzeichnungsmedium, umfassend Programmcode-Abschnitte, die ausgestaltet sind, um das Verfahren nach irgendeinem der Ansprüche 9 - 13 durchzuführen, wenn es auf dem Prozessor (110) ausgeführt ist, der in der Steuerungsschaltung (100) nach irgendeinem der Ansprüche 1 - 7 umfasst ist.

## Revendications

1. Circuit de contrôle (100) pour contrôler une source de lumière UV (204) configurée pour émettre de la lumière UV dans une chambre de purification (202) d'un dispositif (200) de purification d'un fluide, le circuit de contrôle (100) comprenant :
un pilote (102) configuré pour fournir un courant de commande (118) à la source de lumière UV (204) ;
un capteur d'écoulement de fluide (104) configuré pour déterminer la présence ou non d'un écoulement de fluide à travers la chambre de purification (202) et pour générer un signal d'écoulement (112) indicatif correspondant ;
un capteur de lumière (106) configuré pour mesurer le flux énergétique de la lumière émise par la source de lumière UV (204) avant que la lumière émise par la source de lumière UV (204) n'entre dans la chambre de purification (202), et pour générer un signal de flux énergétique (114) comprenant des données relatives au flux énergétique mesuré ;
une mémoire (108) comprenant un flux énergétique de référence (116) ; et
un processeur (110) configuré pour :
lorsque le signal d'écoulement (112) indique la présence d'un écoulement de fluide à travers la chambre de purification (202), activer la source de lumière UV (204),
alors que la source de lumière UV (204) est activée en raison de la présence d'un écoulement de fluide à travers la chambre de purification (202), déterminer le courant de commande (118) pour le pilote (102) sur la base du flux énergétique mesuré compris dans le signal de flux énergétique (114) et du flux énergétique de référence (116) ; et
lorsque le signal d'écoulement (112) indique la non-présence d'un écoulement de fluide à travers la chambre de purification (202), commander au pilote d'appliquer un courant de commande (118) inférieur à un seuil à la source de lumière UV (204), dans lequel le seuil est réglé de telle sorte que le flux énergétique de lumière UV émis par la source de lumière UV soit ≤ 5 % d'un flux énergétique maximal de lumière UV émise par la source de lumière UV.

2. Circuit de contrôle (100) selon la revendication 1, dans lequel le processeur (110) est configuré pour déterminer le courant de commande (118) pour le pilote (102) en déterminant une dégradation de la source de lumière UV (204) sur la base du flux énergétique mesuré compris dans le signal de flux énergétique (114) et du flux énergétique de référence (116), et pour déterminer le courant de commande (118) pour le pilote (102) sur la base de la dégradation de la source de lumière UV (204).

3. Circuit de contrôle (100) selon la revendication 1 ou 2, dans lequel le processeur (110) est configuré pour :
déterminer une période de non-présence d'écoulement de fluide à travers la chambre de purification (202), et
lorsque la durée de la période de non-présence d'un écoulement de fluide à travers la chambre de purification (202) est supérieure à un seuil, activer la source de lumière UV (204).

4. Circuit de contrôle (100) selon l'une quelconque des revendications 1 à 3, dans lequel le capteur d'écoulement de fluide (104) est en outre configuré pour mesurer un débit d'un fluide s'écoulant à travers la chambre de purification (202), dans lequel le signal d'écoulement (112) comprend des données relatives au débit mesuré, et dans lequel le processeur (110) est en outre configuré pour déterminer le courant de commande (118) pour le pilote (102) sur la base du débit mesuré compris dans le signal d'écoulement (112).

5. Circuit de contrôle (100) selon l'une quelconque des revendications 1 à 4, dans lequel le capteur de lumière (106) est configuré pour mesurer un flux énergétique de lumière UV-C, et dans lequel le flux énergétique de référence (116) est un flux énergétique de référence de lumière UV-C.

6. Circuit de contrôle (100) selon l'une quelconque des revendications 1 à 5, dans lequel la source de lumière UV (204) comprend une ou plusieurs LED UV, dans lequel le circuit de contrôle (100) comprend en outre un capteur de température (120) configuré pour mesurer la température d'une LED UV et pour générer un signal de température (122), dans lequel le processeur (110) est configuré pour, lorsque le signal de température (122) indique que la température de la LED est supérieure à un seuil de température prédéterminé, générer un signal de surchauffe de LED.

7. Circuit de contrôle (100) selon l'une quelconque des revendications 1 à 6, dans lequel le processeur (110) est configuré pour, lorsque le signal de flux énergétique (114) indique que le flux énergétique mesuré est inférieur à un seuil de flux énergétique prédéterminé, générer un signal de panne de source de lumière UV, dans lequel le seuil de flux énergétique prédéterminé est un seuil réglé en usine.

8. Dispositif (200) de purification d'un fluide, le dispositif (200) comprenant :
une chambre de purification (202) comportant une entrée de fluide et une sortie de fluide pour permettre à un écoulement de fluide à purifier de s'écouler à travers la chambre ;
une source de lumière UV (204) configurée pour émettre de la lumière UV dans la chambre de purification (202) ; et
un circuit de contrôle (100) selon l'une quelconque des revendications 1 à 7, configuré pour contrôler la source de lumière UV (204).

9. Procédé de contrôle d'une source de lumière UV (204) configurée pour émettre de la lumière UV dans une chambre de purification (202) d'un dispositif (200) de purification d'un fluide, le procédé comprenant :
la détermination (S02) de la présence ou non d'un écoulement de fluide à travers la chambre de purification (202) ;
lors de la détermination de la présence d'un écoulement de fluide à travers la chambre de purification (202), l'activation (S06) de la source de lumière UV (204) ;
alors que la source de lumière UV (204) est active :
la mesure (S08) d'un flux énergétique émis par la source de lumière UV (204) avant que la lumière émise par la source de lumière UV (204) n'entre dans la chambre de purification (202),
la comparaison (S10) du flux énergétique mesuré à un flux énergétique de référence (116), et
le réglage (S12) d'un courant de commande (118) de la source de lumière UV (204) sur la base de la comparaison ; et
lors de la détermination de la non-présence d'un écoulement de fluide à travers la chambre de purification (202), l'application d'un courant de commande (118) inférieur à un seuil à la source de lumière UV (204), dans lequel le seuil est réglé de telle sorte que le flux énergétique de la lumière UV émise par la source de lumière UV soit ≤ 5 % d'un flux énergétique maximal de lumière UV émise par la source de lumière UV.

10. Procédé selon la revendication 9, comprenant en outre :
la détermination d'une période de non-présence d'un écoulement de fluide à travers la chambre de purification (202), et
lorsque la durée de la période de non-présence d'un écoulement de fluide à travers la chambre de purification (202) est supérieure à un seuil, l'activation de la source de lumière UV (204) pendant une période de 1 à 5 secondes.

11. Procédé selon la revendication 9 ou 10, dans lequel l'étape de détermination (S02) de la présence ou non d'un écoulement de fluide à travers la chambre de purification (202) comprend la mesure d'un débit du fluide s'écoulant à travers la chambre de purification, dans lequel le procédé comprend en outre le réglage du courant de commande de la source de lumière UV sur la base du débit mesuré.

12. Procédé selon l'une quelconque des revendications 9 à 11, dans lequel l'étape de mesure (S08) d'un flux énergétique émis par la source de lumière UV (204) comprend la mesure d'un flux énergétique de lumière UV-C, et dans lequel le flux énergétique de référence (116) est un flux énergétique de référence de lumière UV-C.

13. Procédé selon l'une quelconque des revendications 9 à 12, comprenant en outre la mesure (S14) de la température d'une LED de la source de lumière UV (204), et lorsque la température mesurée est supérieure à un seuil prédéterminé, la génération d'un signal de surchauffe de LED.

14. Procédé selon l'une quelconque des revendications 9 à 13, comprenant en outre, lorsque le flux énergétique mesuré est inférieur à un seuil prédéterminé, la génération (S16) d'un signal de panne de la source de lumière UV.

15. Support d'enregistrement non volatil lisible par un ordinateur comprenant des portions de code de programme configurées pour mettre en oeuvre le procédé selon l'une quelconque des revendications 9 à 13 quand elles sont exécutées sur le processeur (110) compris dans le circuit de contrôle (100) selon l'une quelconque des revendications 1 à 7.
